Europäisches Patentamt

European Patent Office

Office européen des brevets

(19)

(11)  **EP 1 176 600 A1**

(12)  **EUROPÄISCHE PATENTANMELDUNG**

(43) Veröffentlichungstag:
   **30.01.2002   Patentblatt 2002/05**

(51) Int Cl.⁷: **G11C 11/16**

(21) Anmeldenummer: **01116325.0**

(22) Anmeldetag: **05.07.2001**

(84) Benannte Vertragsstaaten:
   **AT BE CH CY DE DK ES FI FR GB GR IE IT LI LU
   MC NL PT SE TR**
   Benannte Erstreckungsstaaten:
   **AL LT LV MK RO SI**

(30) Priorität: **25.07.2000   DE 10036140**

(71) Anmelder: **Infineon Technologies AG
   81669 München (DE)**

(72) Erfinder:
   • **Hoffmann, Kurt
     82024 Taufkirchen (DE)**
   • **Kowarik, Oskar
     85579 Neubiberg (DE)**

(74) Vertreter:
   **Müller . Hoffmann & Partner Patentanwälte
   Innere Wiener Strasse 17
   81667 München (DE)**

(54)   **Verfahren und Anordnung zum zerstörungsfreien Auslesen von Speicherzellen eines
   MRAM-Speichers**

(57)   Die Erfindung betrifft ein Verfahren und eine Anordnung zum zerstörungsfreien selbstnormierenden Auslesen von Speicherzellen eines MRAM-Speichers. Dabei wird ein Lesesignal mit dem vom Speicherinhalt unabhängigen Widerstandswert der Speicherzelle normiert.

## Fig. 1

**Beschreibung**

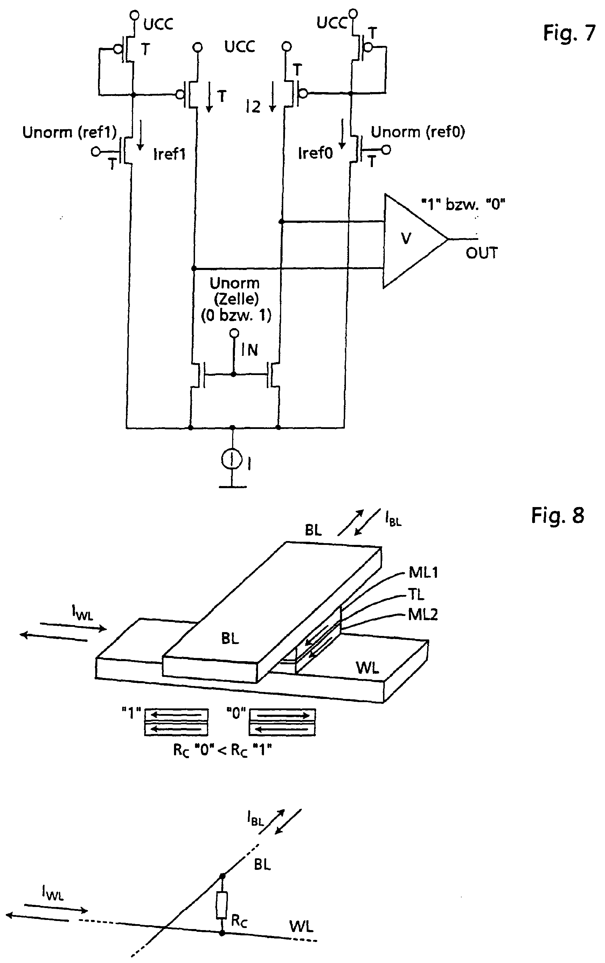

Eine Speicherzelle eines MRAM-Speichers, also eines magnetoresistiven Speichers, ist schematisch in Fig. 8 gezeigt. In einer solchen Speicherzelle wird die zu speichernde Information durch die Art der Ausrichtung der magnetischen Momente in benachbarten magnetisierten Schichten ML1 und ML2, die voneinander durch eine sehr dünne, nicht magnetische Zwischenschicht TL getrennt sind, welche nicht leitend ist, abgespeichert. Die Größe des elektrischen Widerstandes über die Speicherzelle hängt nämlich von der parallelen oder antiparallelen Ausrichtung der magnetischen Momente in den magnetisierten Schichten ML1 und ML2, also deren Polarisation ab. Bei paralleler Ausrichtung der magnetischen Momente in den beiden Schichten ML1 und ML2 ist der Widerstandswert der Speicherzelle in der Regel niedriger als bei deren antiparalleler Ausrichtung. Dieser Effekt wird auch als TMR-Effekt (TMR = "tunneling magneto-resistive") oder als MTJ-Effekt (MTJ = "magnetic tunnel junction") bezeichnet.

Damit kann der Speicherinhalt der Speicherzelle durch die Detektion des für eine "1" bzw. "0" unterschiedlichen Widerstandswertes der Speicherzelle ausgelesen werden. Eine parallele Magnetisierung der beiden Schichten ML1 und ML2 kann beispielsweise einer digitalen Null zugeordnet werden, wobei dann die antiparallele Magnetisierung dieser Schichten einer digitalen Eins entspricht.

Die Widerstandsänderung zwischen einer parallelen und antiparallelen Ausrichtung der magnetischen Momente in den magnetisierten Schichten ML1 und ML2 beruht physikalisch auf der Wechselwirkung der Elektronenpins der Leitungselektronen in der dünnen nichtmagnetischen Zwischenschicht TL mit den magnetischen Momenten in den magnetisierten Schichten ML1 und ML2 der Speicherzelle. Durch "dünn" soll hier zum Ausdruck gebracht werden, daß die Leitungselektronen die Zwischenschicht TL ohne Spin-Streuprozesse durchqueren können.

Vorzugsweise ist eine der beiden magnetisierten Schichten ML1 und ML2 mit ihrer Magnetisierung an eine antiferromagnetische Unterlage oder Deckschicht gekoppelt, wodurch die Magnetisierung in dieser magnetisierten Schicht im wesentlichen fixiert bleibt, während die andere magnetisierte Schicht schon bei kleinen Magnetfeldern, wie sie etwa durch einen Strom in einer Wortleitung WL und einer Bitleitung BL über und unter dieser magnetisierten Schicht erzeugt werden, in ihrem magnetischen Moment frei ausgerichtet werden kann.

In einem Speicherzellenfeld werden Programmierströme $I_{WL}$ und $I_{BL}$ durch die Wortleitung WL bzw. durch die Bitleitung BL so gewählt, daß nur in der Zelle, in welcher sich die Wortleitung WL mit der Bitleitung BL kreuzt, durch die Summe der beiden Ströme $I_{WL}$ und $I_{BL}$ ein zur Programmierung ausreichend starkes Magnetfeld herrscht, während alle anderen an dieser Wortleitung WL bzw. dieser Bitleitung BL liegenden Speicherzellen von dem nur durch eine dieser beiden Leitungen fließenden Strom nicht umprogrammiert werden können.

In der unteren Hälfte von Fig. 8 ist nochmals der Widerstand $R_c$ der Speicherzelle zwischen einer Bitleitung BL und einer Wortleitung WL schematisch veranschaulicht, wobei dieser Widerstand $R_c$ für antiparallele Ausrichtung der magnetischen Momente in den Schichten ML1 und ML2 größer ist als für parallele Ausrichtung dieser magnetischen Momente, d.h. $R_c$ ("0") < $R_c$ ("1"), wenn die obige Annahme für die Zuordnung von "1" bzw. "0" zugrundegelegt wird.

In ihrer einfachsten Ausführungsform bestehen MRAMs aus sich matrixförmig kreuzenden Leiterbahnen der Wortleitungen WL und der Bitleitungen BL, über die die Speicherzellen angesteuert werden. Eine obere Leiterbahn, beispielsweise die Bitleitung BL (vgl. Fig. 8), ist dabei mit der oberen magnetisierten Schicht ML1, z. B. einer Ferromagnetschicht, verbunden, während die untere Leiterbahn, die die Wortleitung WL bildet, an der unteren magnetisierten Schicht ML2, bei der es sich ebenfalls um eine ferromagnetische Schicht handeln kann, anliegt. Wird über die beiden Leiterbahnen für die Wortleitung WL bzw. die Bitleitung BL eine Spannung an die Speicherzelle angelegt, so fließt ein Tunnelstrom durch die dünne nichtmagnetische Zwischenschicht TL. Durch diese dünne nichtmagnetische Zwischenschicht wird dann der Widerstand $R_c$ gebildet, der abhängig von der parallelen oder antiparallelen Ausrichtung der magnetischen Momente, also der parallelen oder antiparallelen Polarisierung der oberen und unteren Ferromagnetschicht bei geeigneter Spannung über der Speicherzelle die Größe $R_c$ ("0") < $R_c$ ("1") bzw. $R_c$ ("1") = $R_c$ ("0") + $\Delta R_c$ annimmt.

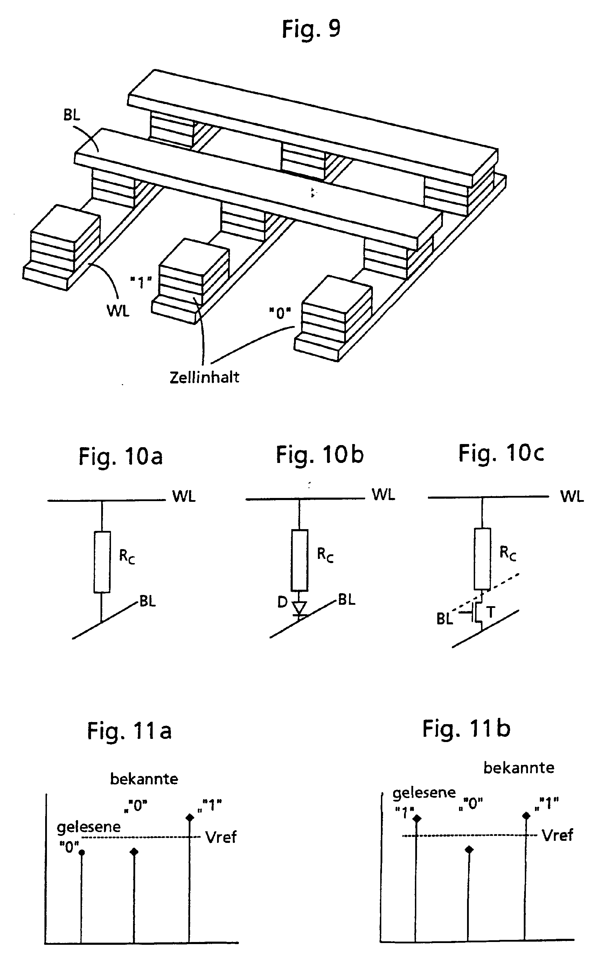

Fig. 9 zeigt ein Speicherzellenfeld, in welchem Speicherzellen matrixartig an Kreuzungsstellen zwischen Wortleitungen WL und Bitleitungen BL angeordnet sind.

Der Zellinhalt ist hier schematisch abhängig von der antiparallelen oder parallelen Polarisierung als "1" bzw. "0" für zwei Speicherzellen angedeutet.

In einem Speicherzellenfeld, wie dieses schematisch in Fig. 9 gezeigt ist, fließt nun ein Strom nicht nur über die Speicherzelle an der Kreuzungsstelle zwischen einer ausgewählten Wortleitung WL und einer ausgewählten Bitleitung BL, sondern es treten unerwünschte Nebenströme auch an weiteren Speicherzellen auf, die jeweils mit der ausgewählten Wortleitung WL bzw. der ausgewählten Bitleitung BL verbunden sind. Diese unerwünschten Nebenströme stören erheblich den Lesestrom, der durch die ausgewählte Speicherzelle fließt.

Es wurden daher bereits Anstrengungen unternommen, durch geeignete Beschaltung des Speicherzellenfeldes solche unerwünschten Nebenströme vom Lesestrom weitgehend zu separieren, so daß nur der Lesestrom durch die ausgewählte Speicherzelle bzw. die Lesespannung über dieser Speicherzelle zur Detektion zur Verfügung steht. Dabei muß aber der Widerstandswert der Speicherzellen wegen der parasitären Ströme durch die anderen Speicherzellen hoch und insbesondere im MOhm-Bereich gewählt werden, um ausreichend große Speicherzellenfelder aufbauen zu können.

Ein anderer Weg, um die unerwünschten Nebenströme zu vermeiden, besteht darin, die an sich einfach aufgebaute MTJ-Speicherzelle (vgl. Fig. 10a) um eine Diode D (vgl. Fig. 10b) oder um einen Schalttransistor T (vgl. Fig. 10c) zu erweitern (R. Scheuerlein e. a., "A 10ns Read and Write Time Non-Volatile Memory Array Using a Magnetic Tunnel Junction and FET-Switch in each Cell", ISSCC Feb. 2000 S. 128/R.c. Sousa e.a., "Vertical Integration of a spin dependent tunnel junction with an amorphous Si diode", appl. Phys. Letter Vol. 74, Nr. 25, S. 3893 bis 3895).

Der Vorteil einer solchen Erweiterung um eine Diode bzw. einen Schalttransistor liegt darin, daß im Speicherzellenfeld bei solcher Beschaltung nur ein Lesestrom durch die jeweils ausgelesene Speicherzelle fließt, da alle übrigen Speicherzellen gesperrt sind. Dadurch kann der Widerstandswert der Speicherzelle im Gegensatz zu einer reinen MTJ-Zelle entsprechend Fig. 10a niedriger gewählt werden, wodurch der Lesestrom relativ groß wird und das Auslesen schnell im ns-Bereich erfolgen kann. Nachteilhaft an einer solchen zusätzlichen Beschaltung mit einer Diode bzw. einem Transistor ist aber der dadurch bedingte erhebliche zusätzliche Technologie- und Flächenaufwand.

Beim derzeitigen Stand der Technik ist allen Speicherzellentypen gemeinsam, daß die Detektion bzw. Bewertung eines Lesesignales als "0" oder "1" sehr schwierig ist, da der durch die Schichtenfolge der Schichten ML1, TL und ML2 gebildete Tunnelwiderstand in der Regel nicht nur über einen Wafer hinweg, sondern sogar in vielen Fällen zwischen benachbarten Speicherzellen sehr viel stärker, d.h. bis zu 40 %, schwankt als der Unterschied des Widerstands $\Delta R_C$ zwischen einem "1"-Zustand und einem "0"-Zustand, der beispielsweise lediglich 15 % beträgt. Mit anderen Worten, durch diese Gegebenheiten wird eine sichere Detektion des Inhalts einer Speicherzelle erheblich erschwert oder sogar unmöglich gemacht.

Bei von MRAMs abweichenden, anderen Speichertypen erfolgt die Detektion einer "1" oder einer "0" aus einem Strom- oder Spannungs-Lesesignal dadurch, daß dieses Lesesignal entweder mit einem Referenzstrom oder einer Referenzspannung verglichen wird, die in der Mitte zwischen dem Lesestrom bzw. einer Lesespannung für eine "1" und dem Lesestrom bzw. der Lesespannung für eine "0" liegen sollte, um so für beide digitalen Werte jeweils den besten Störabstand zu erreichen. Dieser Referenzstrom bzw. diese Referenzspannung kann über Referenzquellen oder aber auch über Referenzzellen, in die fest eine "1" und eine "0" eingeschrieben wurde, erzeugt werden.

Ein solches Vorgehen ist aber allenfalls eingeschränkt, wenn überhaupt, zur Detektion des Lesesignales bei einer MTJ-Zelle einsetzbar, was auf die eingangs geschilderte starke Schwankung des Tunnelwiderstandes von Speicherzelle zu Speicherzelle und über dem gesamten Wafer zurückzuführen ist.

Zur Lösung der oben aufgezeigten Problematik gibt es bisher lediglich zwei Ansätze:

Bei einem ersten Ansatz (vgl. hierzu R. Scheuerlein e.a. "A 10ns Read and Write Time Non-volatile Memory Array Using a Magnetic Tunnel Junction and FET-Switch in each Cell", ISSCC Feb. 2000, S. 128) eignet sich für MTJ-Zellen mit Schalttransistor (vgl. Fig. 10c) und besteht darin, zwei benachbarte Komplementär-Speicherzellen zur Speicherung nur eines Zellinhaltes zu verwenden, wobei immer der Speicherinhalt in die erste Speicherzelle und das Komplement des Speicherinhalts, also der negierte Speicherinhalt, in die zweite Speicherzelle eingeschrieben wird. Beim Auslesen werden beide Speicherzellen gelesen und die Inhalte detektiert. Das Lesesignal und der Störabstand sind hier doppelt so groß wie beim oben erläuterten, üblichen Referenzverfahren. Allerdings sind auch der Platzbedarf und der Technologieaufwand für zwei Speicherzellen und zwei Schalttransistoren sehr groß, und es muß sichergestellt sein, daß die Widerstandsschwankungen zwischen den beiden benachbarten Komplementärzellen so klein sind, daß eine sichere Detektion erfolgen kann.

Diese Voraussetzung ist bei dem zweiten Ansatz, der auf einer Selbstreferenzierung einer gelesenen reinen MTJ-Speicherzelle (vgl. Fig. 10a) beruht, nicht erforderlich. Hierbei wird wie folgt vorgegangen:

Zunächst wird der Zellinhalt einer ausgewählten Speicherzelle ausgelesen und abgespeichert. Sodann wird in diese Speicherzelle beispielsweise eine "0" einprogrammiert. Der Inhalt der einprogrammierten "0" der Speicherzelle wird sodann ausgelesen und abgespeichert. Der zuerst abgespeicherte Zellinhalt wird mit der abgespeicherten bekannten "0" verglichen und detektiert, und der so detektierte Zellinhalt wird wieder in die Speicherzelle zurückgeschrieben.

Nachteilhaft an einem solchen Vorgehen ist nun, daß bei der Detektion des Lesesignales zu der als Referenz einprogrammierten und wiederausgelesenen "0" ein vordefiniertes halbes Lesesignal hinzugefügt werden muß, wodurch erneut Widerstandsschwankungen Eingang in die Detektion der Speicherzelle finden.

Um nun völlig unabhängig von Widerstandsschwankungen der Speicherzellen zu sein, muß bei dem zweiten Ansatz das soeben erläuterte Verfahren durch das Einschreiben einer "1" vervollständigt werden. Es liegt dann folgender Verfahrensablauf vor:

(a) Der Zellinhalt einer ausgewählten Speicherzelle wird gelesen und abgespeichert.

(b) In die Speicherzellen wird beispielsweise eine "0" einprogrammiert.

(c) Der Inhalt der einprogrammierten "0" der Speicherzelle wird gelesen und abgespeichert.

(d) In die Speicherzelle wird beispielsweise eine "1" einprogrammiert.

(e) Der Inhalt der einprogrammierten "1" der Speicherzelle wird gelesen und abgespeichert.

(f) Der abgespeicherte Zellinhalt aus (a) wird mit der abgespeicherten Größe "1" und "0" aus (c) und (e) verglichen und detektiert, was durch Bildung einer Referenzspannung Vref aus der bekannten "0" und "1" erfolgt, wobei zum Detektieren der gelesenen "1" oder "0" jeweils nur die halbe Lesesignaldifferenz zur Verfügung steht, wie dies für eine gelesene "0" in Fig. 11a und für eine gelesene "1" in Fig. 11b angedeutet ist.

(g) Der detektierte Zellinhalt wird schließlich wieder in die Speicherzelle zurückgeschrieben. Das Verfahren gemäß dem zweiten Ansatz erzeugt durch die eingeschriebenen und gelesenen "1" und "0" die Referenzspannung in der ausgewählten Speicherzelle selbst, so daß Widerstandsschwankungen von Speicherzelle zu Speicherzelle keinen Einfluß auf die Detektion haben. Der Störabstand einer "1" oder einer "0" ist aber nur halb so groß wie bei dem zuerst beschriebenen Verfahren der Komplementärzellen nach dem ersten Ansatz. Der erhebliche Nachteil des Verfahrens nach dem zweiten Ansatz liegt darin, daß insgesamt drei Lesezyklen und drei Schreibzyklen sowie ein Bewertungszyklus erforderlich sind, wodurch der Lesevorgang sehr langsam wird.

Zusammenfassend kann also festgestellt werden, daß beim ersten Ansatz der doppelte Platzbedarf und zwischen benachbarten Speicherzellen geringe Widerstandsschwankungen erforderlich sind, während der zweite Ansatz mit insgesamt sieben Zyklen einen erheblichen Zeitaufwand für einen Lesevorgang verlangt.

Es ist daher Aufgabe der vorliegenden Erfindung, ein Verfahren zum zerstörungsfreien Auslesen von Speicherzellen eines MRAM-Speichers zu schaffen, das bei geringem Platzbedarf für jeden Lesevorgang weniger Zeit erfordert; außerdem soll eine Anordnung zur Durchführung dieses Verfahrens angegeben werden.

Diese Aufgabe wird bei einem Verfahren der eingangs genannten Art erfindungsgemäß durch die folgenden Verfahrensschritte gelöst:

(a) Bestimmen eines Normwiderstandswertes Rnorm einer Speicherzelle bei einer Spannung, bei der der Widerstandswert der Speicherzelle unabhängig von deren Zellinhalt ist,

(b) Bestimmen des tatsächlichen Widerstandswertes R(0) bzw. R(1) der Speicherzelle bei einer Spannung, bei der der Widerstandswert der Speicherzelle von deren Zellinhalt abhängig ist,

(c) Normieren des tatsächlichen Widerstandswertes mittels des Normwiderstandswertes durch Bilden von

$$Rnorm(0) = R(0)/Rnorm \text{ bzw.}$$

$$Rnorm(1) = R(1)/Rnorm \text{ und}$$

(d) Vergleichen von Rnorm(0) bzw. Rnorm(1) mit einem normierten Referenzwiderstand

$$Rnormref = (Rnorm(0)ref + Rnorm(1)ref)/2 \text{ und}$$

(e) Detektieren des Speicherzelleninhalts als 0 oder 1 abhängig von dem Vergleichsergebnis.

Vorteilhafte Weiterbildungen der Erfindung ergeben sich aus den Unteransprüchen.

Bei dem erfindungsgemäßen Verfahren bzw. der erfindungsgemäßen Anordnung wird so eine Eigenschaft von MTJ-Speicherzellen ausgenutzt, die bisher noch kaum beachtet wurde. Der Widerstandswert des Tunnelwiderstandes einer Speicherzelle ist nämlich von der an dieser anliegenden Spannung abhängig. Dabei gibt es Spannungsbereiche, in denen der Tunnelwiderstand unabhängig von den Richtungen der Polarisierungen in den beiden magnetisierten Schichten die gleiche Größe hat, also für "1" und "0" gleich groß ist. In anderen Spannungsbereichen ist dagegen bei antiparalleler Orientierung der Polarisation in den beiden magnetisierten Schichten der Widerstand um $\Delta R$ größer als bei paralleler Orientierung der Polarisation in diesen Schichten, so daß hier bei dieser Spannung der Zellinhalt nach "0" und "1" unterschieden werden kann.

Das erfindungsgemäße Verfahren beruht nun darauf, daß in dem zuerst genannten Spannungsbereich, der mit U1 bezeichnet werden soll, der Widerstand $R_c$ der Speicherzelle unabhängig von deren Inhalt bestimmt werden kann, während in dem an zweiter Stelle genannten Spannungsbereich, der mit U2 angegeben werden soll, dieser Widerstand $R_c$ abhängig vom Zellinhalt detektierbar ist. Es ist damit möglich, den vom Zellinhalt abhängigen Widerstand $R_c(U2)$ mittels des vom Zellinhalt unabhängigen Widerstand $R_c(U1)$ so zu normieren, daß der Inhalt verschiedener Speicherzellen, die nicht benachbart sein müssen, wieder miteinander verglichen werden kann. Damit ist es auch möglich, das normierte Lesesignal einer adressierten Speicherzelle mit einem normierten Referenzsignal einer Referenzzelle, die immer jeweils mit einer "0" bzw. einer "1" beschrieschrieben wird, zu vergleichen und damit den Inhalt der Speicherzelle als "1" oder "0" zu detektieren.

Nachfolgend wird die Erfindung anhand der Zeichnungen näher erläutert. Es zeigen:

Fig. 1 die Abhängigkeit des Tunnelwiderstandes für parallele (RP) und antiparallele (RA) Polarisation der magnetisierten Schichten einer Speicherzelle in Abhängigkeit von der an die Speicherzelle angelegten Spannung V = $V_{oben}$ - $V_{unten}$ in Kurven I bzw. das Widerstandsverhältnis MR = (RA - RP)/RP in einer Kurve II,

Fig. 2 eine schematische Darstellung zur weiteren Erläuterung der Abhängigkeit des Widerstandes einer Speicherzelle von der über der Speicherzelle liegenden Spannung, wobei hier der Flächenwiderstand in Abhängigkeit von der Kontaktspannung aufgetragen ist,

Fig. 3 ein schematisches Schaltbild für ein Ausführungsbeispiel einer Grundschaltung zur Normierung eines Lesesignals,

Fig. 4a bis 4c schematische Schaltbilder zur Erläuterung des Ablaufes des erfindungsgemäßen selbstnormierenden Verfahrens am Beispiel eines Speicherzellenfeldes mit MTJ-Speicherzellen,

Fig. 5 ein schematisches Schaltbild zur Erläuterung der Referenzierung eines normierten Lesesignales mittels normierter Referenzsignale für "1" und "0",

Fig. 6 ein schematisches Schaltbild zur Erläuterung der Durchführung einer selbstnormierten Detektion eines Zellsignals,

Fig. 7 eine konkrete Schaltung zur Detektierung des Zellsignals,

Fig. 8 eine schematische Darstellung einer MTJ-Speicherzelle mit einem Ersatzschaltbild,

Fig. 9 eine schematische Darstellung der Zellarchitektur für eine MTJ-Speicherzelle,

Fig. 10a bis 10c Ersatzschaltbilder einer MTJ-Speicherzelle, einer MTJ-Speicherzelle mit einer Diode und einer MTJ-Speicherzelle mit einem Transistor und

Fig. 11a und 11b schematische Darstellungen zur Erläuterung der Detektion einer "0" und einer "1" bei einem bekannten Verfahren.

Die Fig. 8 bis 11b sind bereits eingangs erläutert worden.

In den Figuren werden einander entsprechende Bauteile jeweils mit den gleichen Bezugzeichen versehen.

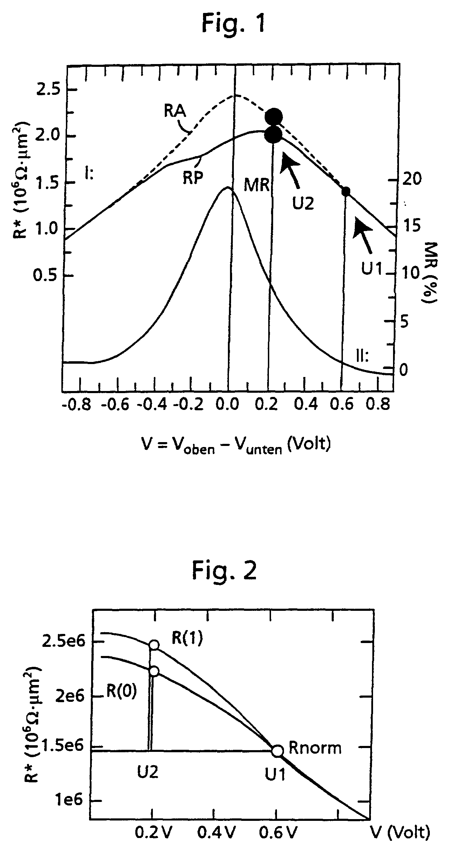

Fig. 1 zeigt den Flächenwiderstandswert R* des Tunnelwiderstandes einer Speicherzelle in Abhängigkeit von der an die Speicherzelle angelegten Spannung V = $V_{oben}$ - $V_{unten}$, wobei $V_{oben}$ beispielsweise an der Bitleitung BL und $V_{unten}$ an der Wortleitung WL (vgl. Fig. 8) anliegen. In einem Spannungsbereich zwischen etwa -0,6 V und +0,6 V ist der Widerstandswert RA bei antiparalleler Polarisation der magnetisierten Schichten größer als der Widerstandswert RP bei deren paralleler Polarisation. Dagegen ist in Spannungsbereichen zwischen -1,0 V und -0,6 V und zwischen 0,6 V und 1,0 V der Widerstandswert für antiparallele Polarisation und parallele Polarisation der magnetisierten Schichten ungefähr gleich groß. Für eine Spannung U2 = 0,2 V ist also RA größer als RP, während für eine Spannung U1 = 0,6 V ungefähr RP (U1) = RA (U1) gilt. Für U2 gilt dagegen RA (U2) = RP (U2) + ΔR.

Mit anderen Worten, bei der Spannung U2 ist es möglich, den Inhalt einer Speicherzelle zu detektieren, während bei Anlegen der Spannung U1 ein für parallele und antiparallele Polarisation der magnetisierten Schichten gleicher Widerstandswert erhalten wird, der zur Normierung des Widerstandswertes der Speicherzelle herangezogen werden kann.

Das erfindungsgemäße Verfahren beruht nun grundsätzlich darauf, daß bei der Spannung U1 der Widerstandswert $R_c$(U1) der Speicherzelle unabhängig vom Zellinhalt bestimmt werden kann, während bei der Spannung U2 der Widerstandswert $R_c$(U2) der Speicherzelle abhängig vom Zellinhalt detektierbar ist. Hierdurch ist es möglich, den vom Zellinhalt abhängigen Widerstand $R_c$(U2) mittels des vom Zellinhalt unabhängigen Widerstandes $R_c$(U1) zu normieren, also $R_c$(U2)/$R_c$(U1) zu bilden, so daß der Zellinhalt verschiedener Speicherzellen, die nicht benachbart zueinander sein müssen, wieder miteinander verglichen werden kann. Mit dem erfindungsgemäßen Verfahren ist es also möglich, das normierte Lesesignal einer adressierten Speicherzelle mit normierten Referenzsignalen von beispielsweise Referenzspeicherzellen zu vergleichen, die immer jeweils mit einer "0" und einer "1" beschrieben sind, so daß der Zellinhalt der adressierten Speicherzelle als "1" oder "0" detektiert werden kann.

Dieser Vorgang soll anhand von Fig. 2, in welcher wieder der Flächenwiderstand R∗ in Abhängigkeit von der Kontaktspannung V aufgetragen ist, nochmals näher erläutert werden.

Zunächst wird der Normwiderstandswert Rnorm bei beispielsweise der Spannung U1 = 0,6 V ermittelt und abgespeichert. Sodann wird bei der Spannung U2 = 0,2 V der Zellinhalt mit dem Widerstandswert R(0) bzw. R(1) abhängig von der antiparallelen (R(1)) bzw. parallelen (R(0)) Polarisation der magnetisierten Schichten festgelegt. Es folgt dann die Normierung von R(0) bzw. R(1) auf Rnorm, d.h. es werden Rnorm(0) = R(0)/Rnorm bzw. Rnorm(1) = R(1)/Rnorm gebildet. Es schließt sich dann ein Vergleich von Rnorm(0) bzw. Rnorm(1) mit einem Referenzwiderstandswert Rnormref = (Rnorm(0)ref + Rnorm(1)ref)/2 einer Referenzspeicherzelle an, welcher zuvor festgelegt wurde. Schließlich wird der Zellinhalt als "0" oder "1" als Ergebnis dieses Vergleiches detektiert.

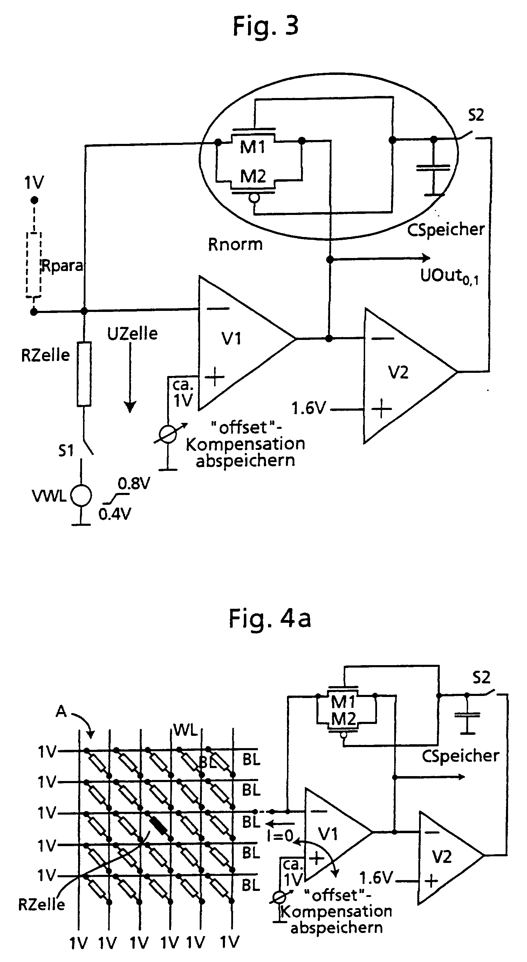

Wie weiter unten anhand des Ausführungsbeispieles von Fig. 3 näher erläutert werden wird, läßt sich das erfindungsgemäße Verfahren in zwei Zeitschritten für die Spannungen U1 und U2 ausführen.

Damit ermöglicht das erfindungsgemäße Verfahren speziell die folgenden Vorteile:

Das erfindungsgemäße Verfahren läßt sich unabhängig von der Streuung von Widerstandswerten von Speicherzellen durchführen. Sein Ablauf erfordert lediglich zwei Zeitschritte. Durch die Normierung des Lesesignals wird ein Vergleich mit externen Referenzsignalen möglich. Es ist somit den bestehenden, eingangs erläuterten Verfahren in jeder Hinsicht überlegen. Schließlich kann das erfindungsgemäße Verfahren auf alle Typen der verschiedenen MTJ-Speicherzellen, also auf reine MTJ-Speicherzellen, auf MTJ-Speicherzellen mit Dioden und MTJ-Speicherzellen mit Transistoren angewandt werden.

Fig. 3 zeigt ein Ausführungsbeispiel einer Anordnung zur Durchführung des erfindungsgemäßen Verfahrens. Mit dieser Anordnung ist prinzipiell die Normierung eines Lesesignales möglich. Die Anordnung weist insbesondere eine Speicherzelle mit einer Widerstand RZelle auf, die über einen Schalter S1, beispielsweise einen Transistor, an einer Wortleitungsspannung VWL von 0,4 V oder 0,8 V liegt. Außerdem sind ein erster Differenzverstärker V1, dessen negativer Eingang mit dem dem Schalter S1 gegenüberliegenden Ende des Widerstandes RZelle verbunden ist und an dessen positivem Eingang eine Spannung von beispielsweise etwa 1 V liegt, ein zweiter Differenzverstärker V2, dessen negativer Eingang mit dem Ausgang des ersten Differenzverstärkers V1 verbunden ist und an dessen positivem Eingang eine Spannung von 1,6 V liegt, ein p-Kanal-MOS-Feldeffekttransistor und eine Speicherkapazität CSpeicher sowie ein weiterer Schalter S2 vorhanden. In Fig. 3 (und den Fig. 4a bis 4c) ist noch ein n-Kanal-MOS-Feldeffekttransistor M1 gezeigt. Wird dieser Feldeffekttransistor M1 anstelle des Feldeffekttransistors M2 verwendet, so müssen der (+)- und (-)-Eingang des zweiten Differenzverstärkers V2 vertauscht.

Im folgenden wird davon ausgegangen, daß nur der Transistor M2 vorhanden ist, während der Transistor M1 nicht vorgesehen ist.

Die Schaltung aus den beiden Transistoren M1 und M2, der Speicherkapazität CSpeicher und dem Trennschalter S2 dient zur Zwischenspeicherung des Normierungswiderstandes Rnorm = RZelle(U1).

Durch Strichlinien sind noch parasitäre Widerstände Rpara anderer Speicherzellen repräsentiert.

Am positiven bzw. (+)-Eingang des ersten Verstärkers V1 liegt die Spannung von 1 V (positiv) plus "offset"-Kompensation so an, daß zwischen dem positiven Eingang und dem negativen bzw. (-)-Eingang des Verstärkers V1 0 V abfallen. Das heißt, am negativen Eingang des ersten Verstärkers V1 liegen genau 1 V an. Auch die übrigen Leitungen des Speicherzellenfeldes mit Ausnahme der ausgewählten Leitungen liegen auf beispielsweise 1 V.

Am positiven Eingang des zweiten Verstärkers V2 wird die Spannung so vorgegeben, daß die Spannung am Ausgang des ersten Verstärkers V1 die Spannung am negativen Eingang des ersten Verstärkers V1, also beispielsweise 1 V, zuzüglich der Spannung UZelle, die über RZelle abfällt, also beispielsweise 0,6 V, die zur Bestimmung des Normierungswiderstandes Rnorm über der adressierten Speicherzelle anliegt, erreicht. Mit anderen Worten, am positiven Eingang des zweiten Verstärkers V2 liegen beispielsweise 1 V + 0,6 V = 1,6 V an.

Durch diese Spannungsvorgaben wird erreicht, daß der zweite Verstärker V2 Transistor M2 bei geschlossenem Schalter S2 so ansteuert, daß über diesem Transistor M2 genau die gleiche Spannung von beispielsweise 0,6 V wie über der Speicherzelle abfällt. Das heißt, an dem Transistor liegt ebenfalls die Spannung UZelle.

Damit fließt durch den Transistor M2 der gleiche Strom wie durch die Speicherzelle. Das heißt, durch den Transistor M2 wird der Normierungswiderstand Rnorm nachgebildet. Wird nun der Schalter S2 geöffnet, so bleibt der Widerstandswert Rnorm in dem Transistor M2 bzw. in der Speicherkapazität CSpeicher gespeichert.

Durch Anlegen einer anderen Spannung als 1,6 V am positiven Eingang des zweiten Verstärkers V2, wie beispielsweise durch Anlegen von 1,3 V an diesem Eingang, läßt sich die Verstärkung des rückgekoppelten ersten Verstärkers V1 einstellen, wie beispielsweise auf eine 2-fache Verstärkung bei 1,3 V.

Die Arbeitsweise der Schaltungsanordnung von Fig. 3 kann mit den Spannungswerten des Beispiels von Fig. 2 wie folgt zusammengefaßt werden:

Zunächst soll die Wortleitung auf 1 V liegen, so daß VWL = 1 V vorliegt. Die Schalter S1 und S2 sind geschlossen, so daß damit an allen Leitungen des Speicherzellenfeldes die 1 V anliegen. Am negativen Eingang des ersten Verstärkers V1 sollen zur "Offset"-Kompensation ebenfalls 1 V liegen.

Dieser Zustand, in welchem ein Strom I = 0 in ein Speicherzellenfeld bzw. -array A aus m x n MTJ-Speicherzellen fließt, ist in Fig. 4a veranschaulicht.

Sodann wird an die Wortleitungen eine Spannung UWL1 = 0,4 V gelegt, so daß die Spannung, die über dem Widerstand RZelle einer Speicherzelle abfällt, 1 V (Bitleitung) - 0,4 V (Wortleitung) = 0,6 V = U1 beträgt. Der zweite Verstärker V2 regelt den Transistor M2 nun so, daß über diesen ebenfalls genau 0,6 V abfallen. Ein Strom $I_{RZelle}$ durch die Speicherzelle ist somit gleich zu dem Strom durch den Transistor M2, so daß RZelle (U1 = 0,6 V) = $R_{M2}$ = Rnorm vorliegt. Der Schalter S2 wird sodann geöffnet, wodurch Rnorm im Transistor M2 sowie der Speicherkapazität CSpeicher abgespeichert wird.

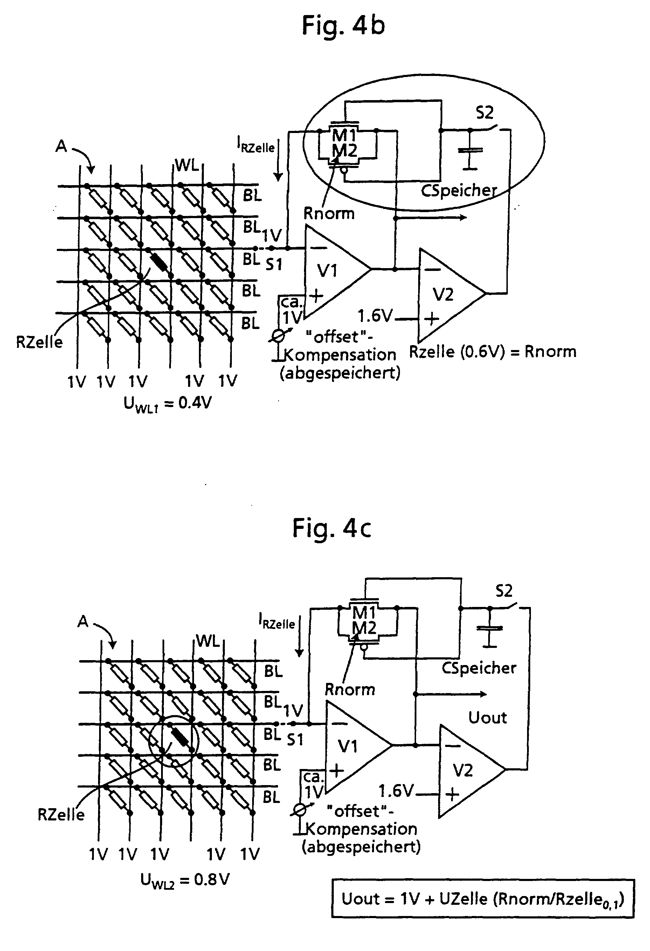

Der nunmehr erreichte Zustand ist in Fig. 4b schematisch gezeigt.

Die Wortleitung wird nunmehr auf eine Spannung von beispielsweise 0,8 V gebracht, so daß $U_{WL2}$ = 0,8 V vorliegt. Die Spannung über dem Widerstand RZelle einer Speicherzelle beträgt dann 1,0 V (Bitleitung) - 0,8 V (Wortleitung) = 0,2 V. Der erste Verstärker V1 liefert damit ein normiertes Lesesignal $Uout_{0,1}$ = 1 V + U2 ($Rnorm/RZelle_{0,1}$).

Der nunmehr erreichte Zustand ist in Fig. 4c veranschaulicht.

Schließlich wird $Uout_{0,1}$ mit einer Referenzspannung verglichen und als "1" oder "0"-Signal detektiert.

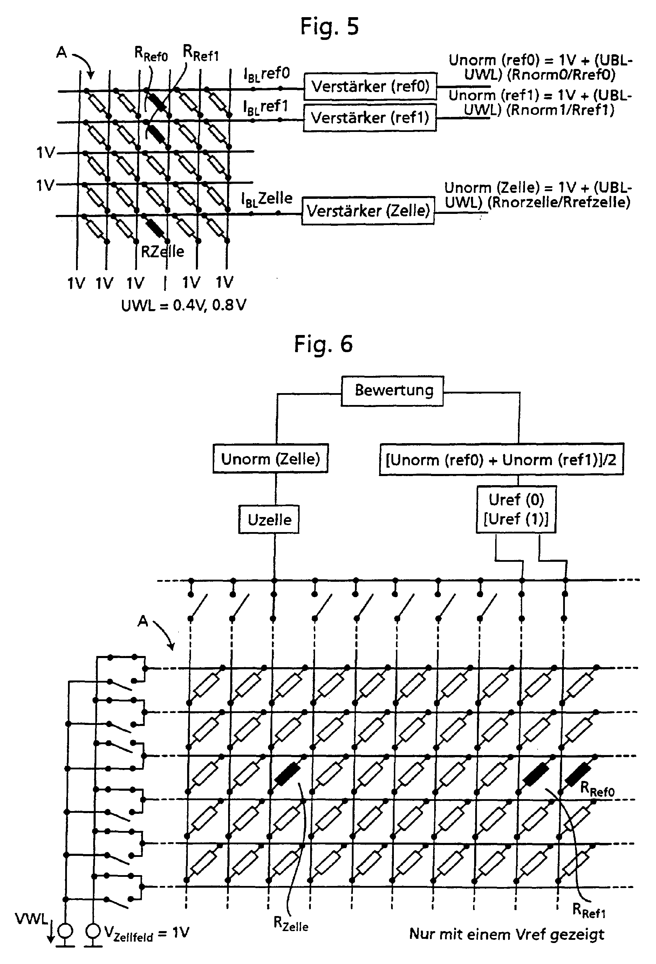

Fig. 5 zeigt ein Beispiel einer Schaltungsanordnung für eine mögliche Referenzierung eines Lesesignales mit Hilfe von Referenzzellen $R_{Ref0}$ und $R_{Ref1}$, in welche jeweils eine "0" und eine "1" fest eingeschrieben sind. Hierbei werden an die Referenzzelle $R_{Ref1}$, in die zuvor eine "1" eingeschrieben wurde, und an die Referenzzelle $R_{Ref0}$, in die zuvor eine "0" eingeschrieben wurde, die gleiche Spannung UWL wie an die auszulesende Zelle $R_{Zelle}$ gelegt. Dabei sind die Referenzzellen $R_{Ref0}$ und $R_{Ref1}$ und die auszulesende Zelle $R_{Zelle}$ jeweils mit einem Verstärker "Verstärker(ref1)", einem Verstärker "Verstärker(ref0)" und einem Verstärker "Verstärker(Zelle)" verbunden, um jeweils ein normiertes Signal Unorm(ref1), Unorm(ref0) und Unorm(Zelle) zu generieren, das gegeben ist durch Unorm(ref1) = 1 V + (UBL - UWL) (Rnorm1/Rref1), Unorm(ref0) = 1 V + (UBL - UWL) (Rnorm0/Rref0) und Unorm(Zelle) = 1 V + (UBL - UWL) (Rnormzelle/Rrefzelle). Durch Vergleich des normierten Zellsignales mit dem aus den normierten Referenzzellsignalen Unorm(ref0) und Unorm(ref1) gewonnenen Referenzsignal Unormref = (Unorm(ref0) + Unorm(ref1))/2 kann dann, wie in Fig. 6 gezeigt ist, in einem Bewertungsschritt der Zellinhalt der Zelle Rzelle im Speicherfeld A detektiert werden.

Ein Beispiel für eine mögliche Bewerterschaltung, die die Bewertung in Fig. 6 vornimmt, ist schließlich in Fig. 7 dargestellt. Transistoren T dieser Schaltung sind dabei so zu dimensionieren, daß an einem Ausgang OUT der Bewerterschaltung je nach dem in einer Speicherzelle gespeicherten Inhalt eine "1" oder eine "0" angezeigt wird.

Die in Fig. 7 gezeigte Bewerterschaltung liegt dabei zwischen Versorgungsspannungen UCC und einer Stromquelle I. Dieser Bewerterschaltung wird der Zellinhalt Unorm(Zelle) an einem Eingang IN zugeführt und mit (Unorm(ref0) + Unorm(ref1))/2 verglichen und über einen Verstärker V zum Ausgang OUT abgegeben.

## Patentansprüche

1. Verfahren zum zerstörungsfreien Auslesen von Speicherzellen eines MRAM-Speichers, **gekennzeichnet durch** die folgenden Verfahrensschritte:

   (a) Bestimmen eines Normwiderstandswertes (Rnorm) einer Speicherzelle bei einer Spannung, bei der der Widerstandswert der Speicherzelle unabhängig von deren Zellinhalt ist,

   (b) Bestimmen des tatsächlichen Widerstandswertes R(0) bzw. R(1) der Speicherzelle bei einer Spannung, bei der der Widerstandswert der Speicherzelle von deren Zellinhalt abhängig ist,

   (c) Normieren des tatsächlichen Widerstandswertes mittels des Normwiderstandswertes durch Bilden von

   $$Rnorm(0) = R(0)/Rnorm \text{ bzw.}$$

   $$Rnorm(1) = R(1)/Rnorm$$

   (d) Vergleichen von Rnorm(0) bzw. Rnorm(1) mit einem Referenzwert und

   (e) Detektieren des Speicherzelleninhalts als 0 oder 1 abhängig von dem Vergleichsergebnis.

2. Verfahren nach Anspruch 1, **dadurch gekennzeichnet, daß** der Schritt (d) wie folgt durchgeführt wird: Vergleichen von Rnorm(0) bzw. Rnorm(1) mit einem normierten Referenzwiderstand Rnormref = (Rnorm(0)ref + Rnorm(1)ref)/2 wobei Rnorm(0)ref und Rnorm(1)ref der entsprechend Schritt (c) normierte Widerstandswert einer Referenzspeicherzelle mit dem Inhalt 0 bzw. 1 bedeutet.

3. Verfahren nach Anspruch 1 oder 2,
**dadurch gekennzeichnet,**
**daß** das Bestimmen des Normwiderstandswertes bei Spannungen zwischen 0,6 und 0,8 V an der Speicherzelle vorgenommen wird.

4. Verfahren nach einem der Ansprüche 1 bis 3,
**dadurch gekennzeichnet,**
**daß** der Widerstandswert einer Speicherzelle bei einer angelegten Spannung von etwa 0,2 V gemessen wird.

5. Anordnung zur Durchführung des Verfahrens nach einem der Ansprüche 1 bis 4,
**dadurch gekennzeichnet,**
**daß** die Speicherzelle (RZelle) mit einer Transistorschaltung (M1, M2, CSpeicher) verbunden ist, in der der Normwiderstandswert der Speicherzelle (RZelle) abgespeichert wird.

6. Anordnung nach Anspruch 5,
**dadurch gekennzeichnet,**
**daß** die Transistorschaltung (M1, M2, CSpeicher) über einen Schalter (S2) an den Ausgang eines Verstärkers (V2) angeschlossen ist.

7. Anordnung nach Anspruch 5 oder 6,
**dadurch gekennzeichnet,**
**daß** der Verstärker (V2) mit einem Eingang (-) mit dem Ausgang eines weiteren Verstärkers (V1) verbunden ist, von dem ein Eingang mit der Speicherzelle (RZelle) verbunden ist.

8. Anordnung nach Anspruch 7,
**dadurch gekennzeichnet,**
**daß** an den beiden anderen Eingängen der Verstärker (V2, V1) jeweils eine feste Spannung anliegt.

9. Anordnung nach einem der Ansprüche 5 bis 8,
**dadurch gekennzeichnet,**
**daß** die Source-Drain-Strecken der beiden Transistoren (M1, M2) parallel geschaltet sind und zwischen der Speicherzelle (RZelle) und einem Ausgang ($UOut_{0,1}$) liegen.

10. Anordnung nach Anspruch 9,
**dadurch gekennzeichnet,**
**daß** die Gateanschlüsse der beiden Transistoren (M1, M2) mit dem Schalter (S2) und einer Speicherkapazität (CSpeicher) verbunden sind.

## Fig. 1

## Fig. 2

# Fig. 3

Rnorm

CSpeicher

S2

1V

Rpara

RZelle

UZelle

UOut$_{0,1}$

V1

V2

ca. 1V

"offset"-Kompensation abspeichern

1.6V

S1

VWL

0.8V

0.4V

# Fig. 4a

A

WL

BL

BL

BL

BL

BL

BL

1V

RZelle

1V 1V 1V 1V 1V 1V

M1 M2

S2

CSpeicher

V1

V2

I=0

ca. 1V

"offset"-Kompensation abspeichern

1.6V

# Fig. 4b

A

WL

BL
BL
BL
BL
BL

$I_{RZelle}$

Rnorm

M1
M2

S2

CSpeicher

1V

S1

V1

ca. 1V

"offset"-Kompensation (abgespeichert)

1.6V

V2

Rzelle (0.6V) = Rnorm

RZelle

1V  1V  1V  1V  1V

$U_{WL1} = 0.4V$

# Fig. 4c

A

WL

BL
BL
BL
BL
BL

$I_{RZelle}$

Rnorm

M1
M2

S2

CSpeicher

1V

S1

V1

Uout

ca. 1V

"offset"-Kompensation (abgespeichert)

1.6V

V2

RZelle

1V  1V  1V  1V  1V

$U_{WL2} = 0.8V$

$$Uout = 1V + UZelle (Rnorm/Rzelle_{0,1})$$

## Fig. 5

A

$R_{Ref0}$  $R_{Ref1}$

$I_{BL}ref0$ → Verstärker (ref0) — Unorm (ref0) = 1V + (UBL-UWL) (Rnorm0/Rref0)

$I_{BL}ref1$ → Verstärker (ref1) — Unorm (ref1) = 1V + (UBL-UWL) (Rnorm1/Rref1)

1V

1V

$I_{BL}Zelle$ → Verstärker (Zelle) — Unorm (Zelle) = 1V + (UBL-UWL) (Rnorzelle/Rrefzelle)

RZelle

1V 1V 1V | 1V 1V

UWL = 0.4V, 0.8V

## Fig. 6

Bewertung

Unorm (Zelle)

[Unorm (ref0) + Unorm (ref1)]/2

Uzelle

Uref (0)
[Uref (1)]

A

VWL
$V_{Zellfeld}$ = 1V

$R_{Zelle}$

$R_{Ref0}$

$R_{Ref1}$

Nur mit einem Vref gezeigt

Fig. 7

UCC

T

UCC

T

↓ T

UCC

T

T

Unorm (ref1)

T ↓ Iref1

I2 ↓

↓

Iref0

Unorm (ref0)

T

V

"1" bzw. "0"

OUT

Unorm
(Zelle)
(0 bzw. 1)

IN

I

Fig. 8

$I_{BL}$

BL

ML1
TL
ML2

$I_{WL}$

BL

WL

"1"          "0"

$R_C$ "0" < $R_C$ "1"

$I_{BL}$

BL

$I_{WL}$

$R_C$          WL

## Fig. 9

BL
WL
"1"
"0"
Zellinhalt

## Fig. 10a

WL
$R_C$
BL

## Fig. 10b

WL
$R_C$
D
BL

## Fig. 10c

WL
$R_C$
BL
T

## Fig. 11a

bekannte
"0"
"1"
gelesene
"0"
Vref

## Fig. 11b

bekannte
gelesene
"1"
"0"
"1"
Vref

**Europäisches Patentamt**

# EUROPÄISCHER RECHERCHENBERICHT

Nummer der Anmeldung

EP 01 11 6325

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | JP 63 275972 A (NIKON CORP) 14. November 1988 (1988-11-14) * Abbildung 6 * ----- | 1 | G11C11/16 |

**RECHERCHIERTE SACHGEBIETE (Int.Cl.7)**

G11C

Der vorliegende Recherchenbericht wurde für alle Patentansprüche erstellt

| Recherchenort | Abschlußdatum der Recherche | Prüfer |
|---|---|---|
| DEN HAAG | 8. November 2001 | Degraeve, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                    EP 01 11 6325

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-11-2001

| Im Recherchenbericht angeführtes Patentdokument | Datum der Veröffentlichung | Mitglied(er) der Patentfamilie | Datum der Veröffentlichung |
|---|---|---|---|
| JP 63275972      A | 14-11-1988 | JP    2005559 C<br>JP    7038015 B | 11-01-1996<br>26-04-1995 |

EPO FORM P0461

Für nähere Einzelheiten zu diesem Anhang : siehe Amtsblatt des Europäischen Patentamts, Nr.12/82